# EUROPEAN PATENT SPECIFICATION

(11) **EP 4 513 489 B1**
(45) Date of publication and mention of the grant of the patent: **09.09.2026**
(21) Application number: 23883985.6
(22) Date of filing: 03.02.2023
(51) Int. Cl.: G11C 7/06, G11C 7/02, G11C 7/08, G11C 7/10, G11C 7/12, G11C 7/18, G11C 29/02, G11C 11/4091, G11C 11/4094, G11C 11/4096, G11C 11/4097, G11C 29/04

(54) **MEMORY**
SPEICHER
MÉMOIRE

(30) Priority: 04.11.2022 CN 202211376117
(43) Date of publication of application: 26.02.2025
(73) Proprietor: CXMT Corporation, Hefei City, Anhui Province 230601 (CN)
(72) Inventor: LUO, Yifei, Hefei, Anhui 230601 (CN); BA, Hangtian, Hefei, Anhui 230601 (CN)
(74) Representative: Gulde & Partner
(86) International application number: PCT/CN2023/074398
(87) International publication number: WO 2024/093037

(56) References cited:
- CN-A- 101 770 806
- CN-A- 102 347 067
- US-A1- 2010 157 702
- US-A1- 2011 069 568
- US-A1- 2011 116 334
- US-A1- 2011 116 334
- US-A1- 2011 199 836
- US-A1- 2012 195 146

## Description

### TECHNICAL FIELD

The present disclosure relates to but is not limited to a memory.

### BACKGROUND

With the popularization of electronic devices such as mobile phones, tablet computers, and personal computers, semiconductor memory technologies are also rapidly developed.

Multiple stages of amplifier circuits are disposed in a dynamic random access memory (DRAM). A voltage difference is amplified by the multiple stages of amplifier circuits to read data from or write data into a storage cell. Therefore, performance of the memory can be improved by improving the multiple stages of amplifier circuits. Background may be found in US20110116334A1, US20110069568A1 and US20100157702A1.

US20110116334A1 discloses that a semiconductor memory device including a bitline sensing amp detecting and amplifying data of a pair of bitlines from a memory cell, a column selecting unit transmitting the data of the pair of bitlines to a pair of local datalines in response to a column selecting signal, a dataline precharging unit precharging the pair of local datalines to a precharging voltage level in response to a precharging signal, and a dataline sensing amp detecting and amplifying data transmitted to the pair of local datalines. The dataline sensing amp includes a charge sync unit discharging the pair of local datalines at the precharging voltage level in response to a first dataline sensing enabling signal and data of the pair of local datalines, and a data sensing unit transmitting data of the pair of local datalines to a pair of global datalines in response to a second dataline sensing enabling signal.

US20110069568A1 discloses that a semiconductor memory device including a plurality of memory cell array blocks, a bit line sense amplifier, a local sense amplifier that can be controlled to be turned on or off, a data sense amplifier, and a controller. The controller activates a local sense control signal for a predetermined duration in response to first and second signals. The first signal is a bit line sense enable signal that activates the bit line sense amplifier, and the local sense amplifier is activated for a predetermined duration after the bit line sense enable signal is activated. The second signal is activated or deactivated in phase with a column selection line signal that connects a pair of bit lines and a pair of local input/output lines. Accordingly, it is possible to turn on or off the local sense amplifier according to operating conditions, thereby increasing a tRCD parameter and reducing the consumption of current. The operating speed of the semiconductor memory device can be improved by combining the local sense amplifier with a current type data sense amplifier that does not require precharging and equalization during a read operation.

US20100157702A1 discloses that a semiconductor memory device capable of preventing or minimizing bit line disturbance and performing a low-voltage high-speed operation includes a read data path circuit including a bit line sense amplifier, a local input/output line sense amplifier, a column selecting unit to operationally connect bit lines connected to the bit line sense amplifier to local input/output lines connected to the local input/output line sense amplifier in response to a column selection signal, and a local input/output line precharging unit to precharge the pair of local input/output lines by a first precharging unit, equalizing the pair of local input/output lines by an equalizing unit, and to precharge the local input/output lines by a second precharging unit following an elapsed time after the bit line sense amplifier is activated, while the column selection is deactivated.

### SUMMARY

The invention is set out in the appended set of claims.

### BRIEF DESCRIPTION OF DRAWINGS

The accompanying drawings herein, which are incorporated in and constitute a part of the specification, illustrate embodiments conforming to the present disclosure, and are used together with the specification to explain the principles of the present disclosure.
FIG. 1 is a schematic diagram of a circuit of a memory;
FIG. 2 is a wiring diagram of a local data line in a memory;
FIG. 3 is a schematic diagram of a principle of an impact of coupling capacitors on voltages on local data lines in a memory;
FIG. 4 is a diagram of an operating principle when there is an impact of coupling capacitors on voltages on local data lines in a memory;
FIG. 5 is a schematic diagram of a circuit of a memory according to an embodiment of the present disclosure;
FIG. 6 is an operational timing diagram of a memory according to an embodiment of the present disclosure; and
FIG. 7 is a diagram of an operating principle of a memory according to an embodiment of the present disclosure.

### Reference numerals:

100. first-stage amplifier circuit; 200. second-stage amplifier circuit; 300. third-stage amplifier circuit; 400. second control circuit; 500. equalizer circuit; 600. driving circuit; 700. first control circuit; 610. first driving unit; 620. second driving unit; 630. switch unit; BL. bit line; BLB. complementary bit line; LIO. local data line; LIOB. complementary local data line; GIO. global data line; GIOB. complementary global data line; M1. first transistor; M2. second transistor; CSL. column selection signal; VintLP. second power supply terminal; RdEnN. first control signal; RdEn. second control signal; CTRLPin. mode signal; RdEnPre. reference signal; P1. first P-type transistor; P2. second P-type transistor; P3. third P-type transistor; and EQLOB. equalization control signal.

The foregoing accompanying drawings already show clear embodiments of the present disclosure, which are described in more detail below. These accompanying drawings and text descriptions are not intended to limit the scope of the concept of the present disclosure in any manner, but to describe the concept of the present disclosure for a person skilled in the art with reference to specific embodiments.

### DESCRIPTION OF EMBODIMENTS

Example embodiments are described herein in detail, and examples thereof are shown in the accompanying drawings. When the following descriptions relate to the accompanying drawings, unless otherwise indicated, the same numbers in different accompanying drawings represent the same or similar elements. Implementations described in the following example embodiments do not represent all implementations consistent with the present disclosure. On the contrary, they are merely examples of apparatuses and methods that are consistent with some aspects of the present disclosure as detailed in the appended claims.

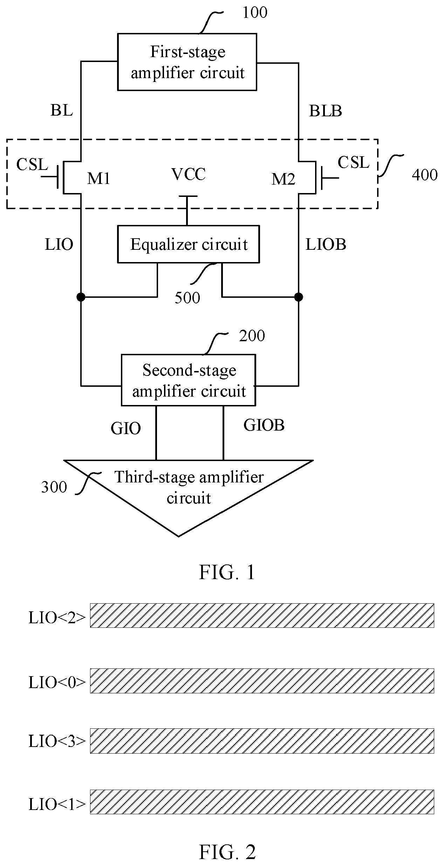

As shown in FIG. 1, a memory includes a first-stage amplifier circuit 100, a second-stage amplifier circuit 200, a third-stage amplifier circuit 300, a second control circuit 400, and an equalizer circuit 500. The first-stage amplifier circuit 100 is connected to a bit line BL and a complementary bit line BLB. The first-stage amplifier circuit 100 is configured to amplify a voltage difference between the bit line BL and the complementary bit line BLB. The second-stage amplifier circuit 200 is connected to a local data line LIO and a complementary local data line LIOB. The second-stage amplifier circuit 200 is further connected to a global data line GIO and a complementary global data line GIOB. The second-stage amplifier circuit 200 is configured to amplify a voltage difference between the local data line LIO and the complementary local data line LIOB, and generate a voltage difference between the global data line GIO and the complementary global data line GIOB. The third-stage amplifier circuit 300 is configured to amplify the voltage difference between the global data line GIO and the complementary global data line GIOB.

The second control circuit 400 is connected to the bit line BL and the complementary bit line BLB. The second control circuit 400 is connected to the local data line LIO and the complementary local data line LIOB. The second control circuit 400 is configured to control connection or disconnection between the bit line BL and the local data line LIO. The second control circuit 400 is further configured to control connection or disconnection between the complementary bit line BLB and the complementary local data line LIOB.

The equalizer circuit 500 is connected to the local data line LIO and the complementary local data line LIOB. The equalizer circuit 500 is configured to charge both of the local data line LIO and the complementary local data line LIOB to a precharge voltage VCC before the bit line BL is connected to the local data line LIO and the complementary bit line BLB is connected to the complementary local data line LIOB.

Charge sharing is performed between a storage cell and the bit line BL before the bit line BL is connected to the local data line LIO and the complementary bit line BLB is connected to the complementary local data line LIOB. A small voltage difference is generated between the bit line BL and the complementary bit line BLB. The small voltage difference between the bit line BL and the complementary bit line BLB is amplified by the first-stage amplifier circuit 100.

The voltage difference is generated between the local data line LIO and the complementary local data line LIOB by the bit line BL and the complementary bit line BLB after the bit line BL is connected to the local data line LIO and the complementary bit line BLB is connected to the complementary local data line LIOB. Then, the voltage difference between the local data line LIO and the complementary local data line LIOB is amplified by the second-stage amplifier circuit 200, so that data is transmitted from the bit line BL and the complementary bit line BLB to the local data line LIO and the complementary local data line LIOB.

FIG. 2 is a wiring diagram of some local data lines LIO in a memory. Multiple local data lines LIO are sequentially arranged. A coupling capacitor exists between two local data lines LIO. Voltages on the local data lines LIO are affected when voltage jump occurs on the coupling capacitor.

For example, four local data lines LIO in FIG. 2 are sequentially marked from top to bottom as a local data line LIO<2>, a local data line LIO<0>, a local data line LIO<3>, and a local data line LIO<1>. A coupling capacitor exists between the local data line LIO<2> and the local data line LIO<3>.

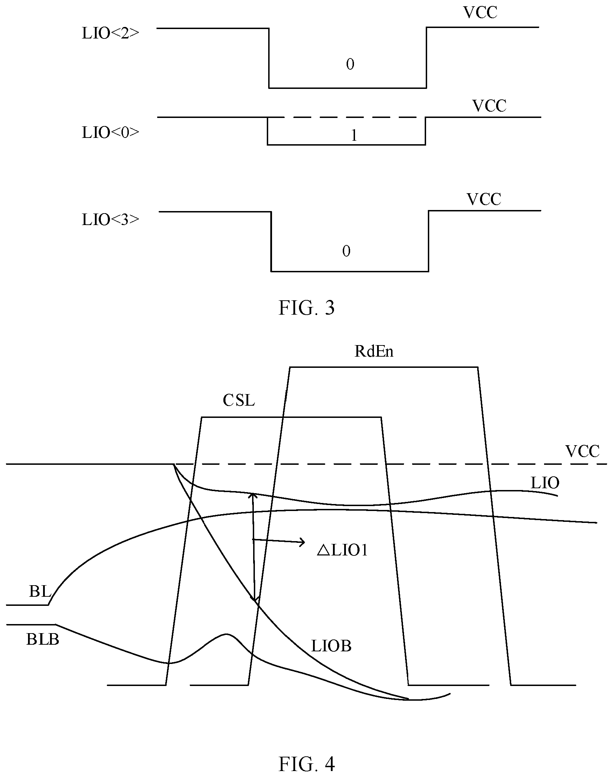

As shown in FIG. 3, voltages on the local data line LIO<2> and the local data line LIO<3> are reduced from the precharge voltage VCC to a voltage corresponding to data "0" due to transmission of the data "0". However, a voltage on the local data line LIO<0> is still close to the precharge voltage VCC when data "1" is transmitted. The voltage on the local data line LIO<0> is affected and reduced by the coupling capacitor between the local data line LIO<2> and the local data line LIO<3> because voltage jump occurs on the local data line LIO<2> and the local data line LIO<3>.

As shown in FIG. 4, a value of a voltage difference △LIO1 is small when a voltage difference between the local data line LIO<0> and a complementary local data line LIOB<0> is amplified by the second-stage amplifier circuit. A longer time is required by the second-stage amplifier circuit 200 to amplify the voltage difference between the local data line LIO<0> and the complementary local data line LIOB<0> to a preset value. A timing parameter tCCD of the memory refers to a time interval between a current column address strobe and a next column address strobe. The timing parameter tCCD of the memory is caused to be poorer by the longer time required by the second-stage amplifier circuit 200 to amplify the voltage difference between the local data line LIO and the complementary local data line LIOB.

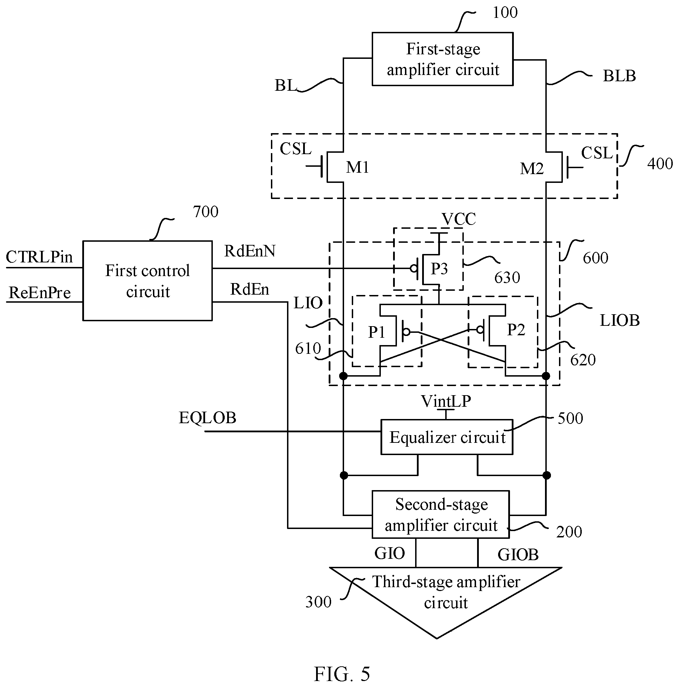

As shown in FIG. 5, an embodiment of the present disclosure provides a memory, including a first-stage amplifier circuit 100, a second-stage amplifier circuit 200, and a driving circuit 600.

The first-stage amplifier circuit 100 is connected to a bit line BL and a complementary bit line BLB. The second-stage amplifier circuit 200 is connected to a local data line LIO and a complementary local data line LIOB. The second-stage amplifier circuit 200 is further connected to a global data line GIO and a complementary global data line GIOB. The driving circuit 600 is connected to the local data line LIO and the complementary local data line LIOB.

Charge sharing is performed between a storage cell and the bit line BL after the local data line LIO is disconnected from the bit line BL and the complementary local data line LIOB is disconnected from the complementary bit line BLB. In this case, a small voltage difference is generated between the bit line BL and the complementary bit line BLB. The first-stage amplifier circuit 100 is configured to amplify the small voltage difference between the bit line BL and the complementary bit line BLB.

The local data line LIO is driven by the bit line BL and the complementary local data line LIOB is driven by the complementary bit line BLB after the local data line LIO is connected to the bit line BL and the complementary local data line LIOB is connected to the complementary bit line BLB, to generate a voltage difference between the local data line LIO and the complementary local data line LIOB. The second-stage amplifier circuit 200 amplifies the voltage difference between the local data line LIO and the complementary local data line LIOB, and generates a voltage difference between the global data line GIO and the complementary global data line GIOB. The voltage difference between the local data line LIO and the complementary local data line LIOB is further amplified by the driving circuit 600 after the voltage difference is generated between the local data line LIO and the complementary local data line LIOB.

In the foregoing technical solution, the driving circuit 600 connected to the local data line LIO and the complementary local data line LIOB is disposed. The voltage difference between the local data line LIO and the complementary local data line LIOB is amplified by the second-stage amplifier circuit 200 after the voltage difference is generated between the local data line LIO and the complementary local data line LIOB. The driving circuit 600 is also configured to amplify the voltage difference between the local data line LIO and the complementary local data line LIOB. Therefore, an impact of coupling capacitors on voltages on the local data lines LIO is compensated for, a time for amplifying the voltage difference between the local data line LIO and the complementary local data line LIOB can be shortened, and a timing parameter tCCD of the memory can be improved.

In some embodiments, continuing to refer to FIG. 5, the memory further includes an equalizer circuit 500. The equalizer circuit 500 is connected to the local data line LIO and the complementary local data line LIOB. Voltages on the local data line LIO and the complementary local data line LIOB are charged to a precharge voltage by the equalizer circuit 500 before the local data line LIO is connected to the bit line BL and the complementary local data line LIOB is connected to the complementary bit line BLB.

The bit line BL and the local data line LIO are controlled to be connected and the complementary bit line BLB and the complementary local data line LIOB are controlled to be connected after the voltages on the local data line LIO and the complementary local data line LIOB are charged to the precharge voltage by the equalizer circuit 500. The voltage difference between the local data line LIO and the complementary local data line LIOB is generated by the bit line BL and the complementary bit line BLB. The voltage difference between the local data line LIO and the complementary local data line LIOB is amplified by the driving circuit 600. The voltage difference between the local data line LIO and the complementary local data line LIOB is also amplified by the second-stage amplifier circuit 200.

In some embodiments, continuing to refer to FIG. 5, the equalizer circuit 500 is connected to a second power supply terminal. A voltage VintLP on the second power supply terminal is adjustable, so that the precharge voltage is also adjustable. The voltage VintLP provided by the second power supply terminal may be adjusted based on the timing parameter of the memory, to adjust the precharge voltage for the local data line LIO and the complementary local data line LIOB.

In some embodiments, the driving circuit 600 is connected and enters a waiting state after the local data line LIO and the complementary local data line LIOB are charged to the precharge voltage and before the bit line BL is connected to the local data line LIO and the complementary bit line BLB is connected to the complementary local data line LIOB. The voltage difference is generated between the local data line LIO and the complementary local data line LIOB by the bit line BL and the complementary bit line BLB after the bit line BL is connected to the local data line LIO and the complementary bit line BLB is connected to the complementary local data line LIOB. The voltage difference between the local data line LIO and the complementary local data line LIOB is amplified by the driving circuit 600.

In some embodiments, the driving circuit 600 is connected after the bit line BL is connected to the local data line LIO and the complementary bit line BLB is connected to the complementary local data line LIOB. The voltage difference between the local data line LIO and the complementary local data line LIOB is directly amplified by the driving circuit 600, and the driving circuit 600 does not need to enter the waiting state.

In the foregoing technical solution, the driving circuit 600 and the second-stage amplifier circuit 200 are controlled after the voltages on the local data line LIO and the complementary local data line LIOB are charged to the precharge voltage, to amplify the voltage difference between the local data line LIO and the complementary local data line LIOB, to implement accurate data transmission between the bit line BL and the local data line LIO and between the complementary bit line BLB and the complementary local data line LIOB.

In some embodiments, continuing to refer to FIG. 5, the memory further includes a second control circuit 400. The second control circuit 400 is connected to the bit line BL and the complementary bit line BLB. The second control circuit 400 is further connected to the local data line LIO and the complementary local data line LIOB. The second control circuit 400 is configured to receive a column selection signal CSL. Connection or disconnection between the bit line BL and the local data line LIO and connection or disconnection between the complementary bit line BLB and the complementary local data line LIOB are controlled by the second control circuit 400 under the control of the column selection signal CSL.

In some embodiments, continuing to refer to FIG. 5, the second control circuit 400 includes a first transistor M1 and a second transistor M2. A source or a drain of the first transistor M1 is connected to the bit line BL. The drain or the source of the first transistor M1 is connected to the local data line LIO. A gate of the first transistor M1 is connected to a column selection line to receive the column selection signal CSL. A source or a drain of the second transistor M2 is connected to the complementary bit line BLB. The drain or the source of the second transistor M2 is connected to the complementary local data line LIOB. A gate of the second transistor M2 is connected to the column selection line to receive the column selection signal CSL.

The first transistor M1 and the second transistor M2 are turned on or off under the control of the column selection signal CSL, to control connection or disconnection between the bit line BL and the local data line LIO and connection or disconnection between the complementary bit line BLB and the complementary local data line LIOB.

In some embodiments, the first transistor M1 and the second transistor M2 are N-type transistors. The first transistor M1 and the second transistor M2 are controlled to be turned on when the column selection signal CSL is at a high level.

In some embodiments, continuing to refer to FIG. 5, the memory further includes a third-stage amplifier circuit 300. The third-stage amplifier circuit 300 is connected to the global data line GIO and the complementary global data line GIOB. The third-stage amplifier circuit 300 is configured to amplify the voltage difference between the global data line GIO and the complementary global data line GIOB.

In some embodiments, a start moment at which the driving circuit 600 amplifies the voltage difference between the local data line LIO and the complementary local data line LIOB is earlier than a start moment at which the second-stage amplifier circuit 200 amplifies the voltage difference between the local data line LIO and the complementary local data line LIOB. Through such a disposition, the voltage difference between the local data line LIO and the complementary local data line LIOB is first amplified by the driving circuit 600 after the voltage difference is generated between the local data line LIO and the complementary local data line LIOB by the bit line BL and the complementary bit line BLB, to compensate for the impact of the coupling capacitors on the voltages on the local data lines LIO. Then, the second-stage amplifier circuit 200 and the driving circuit 600 together amplify the voltage difference between the local data line LIO and the complementary local data line LIOB, and generate the voltage difference between the global data line GIO and the complementary global data line GIOB. Therefore, a time for amplifying the voltage difference between the local data line LIO and the complementary local data line LIOB by the second-stage amplifier circuit 200 is shortened, and performance of the timing parameter tCCD of the memory is improved.

In some embodiments, a first time interval is a time interval tRCD between adjacent row addressing and column addressing of the memory, that is, a time interval between adjacent active command and read command or a time interval between adjacent active command and write command. That is, the first time interval is a time interval from enabling a word line to enabling the column selection line.

A first start moment is a start moment at which the driving circuit 600 amplifies the voltage difference between the local data line LIO and the complementary local data line LIOB.

The first start moment is in a first value range when the first time interval is in a first time range. The first start moment is in a second value range when the first time interval is in a second time range. An upper limit value of the first time range is less than or equal to a lower limit value of the second time range. An upper limit value of the first value range is greater than or equal to a lower limit value of the second value range.

A shorter first time interval indicates a later start moment at which the driving circuit 600 amplifies the voltage difference between the local data line LIO and the complementary local data line LIOB. If the first time interval is short, the voltage difference between the bit line BL and the complementary bit line BLB is smaller when the bit line BL is connected to the local data line LIO and the complementary bit line BLB is connected to the complementary local data line LIOB, and noise is more easily introduced to the bit line BL and the complementary bit line BLB by the local data line LIO and the complementary local data line LIOB. The start moment at which the driving circuit 600 amplifies the voltage difference between the local data line LIO and the complementary local data line LIOB is delayed, to reduce an impact of the local data line LIO and the complementary local data line LIOB on the bit line BL and the complementary bit line BLB, thereby reducing noise introduction.

In some embodiments, the first start moment may be further adjusted based on any one or more parameters of a process angle of the memory, a temperature of the memory, and an operating voltage of the memory, to reduce the noise introduced to the bit line BL and the complementary bit line BLB. Multiple tests may be performed on the memory to determine a relationship between the first start moment and each of the process angle of the memory, the temperature of the memory, and the operating voltage of the memory.

In some embodiments, the driving circuit 600 is configured to amplify the voltage difference between the local data line LIO and the complementary local data line LIOB by driving a voltage on the local data line LIO upward and/or driving a voltage on the complementary local data line LIOB upward. A driving capability of driving the local data line LIO upward or driving the complementary local data line LIOB upward refers to a capability of driving the voltage on the local data line LIO or the complementary local data line LIOB to be raised, and may be measured based on a voltage change rate. The driving capability of driving the local data line LIO upward is negatively correlated with the voltage on the complementary local data line LIOB. The driving capability of driving the complementary local data line LIOB upward is negatively correlated with the voltage on the local data line LIO.

The voltage difference is generated between the local data line LIO and the complementary local data line LIOB, e.g., the voltage on the local data line LIO is greater than the voltage on the complementary local data line LIOB, that is, the voltage on the local data line LIO is large and the voltage on the complementary local data line LIOB is small. The driving capability of the driving circuit 600 in driving the complementary local data line LIOB upward is weak when the voltage on the local data line LIO is large. The driving capability of the driving circuit 600 in driving the local data line LIO upward is strong when the voltage on the complementary local data line LIOB is small. The voltage on the local data line LIO may be caused to be continuously greater than the voltage on the complementary local data line LIOB when the driving capability of the driving circuit 600 in driving the complementary local data line LIOB upward is weak and the driving capability of the driving circuit 600 in driving the local data line LIO upward is strong, thereby amplifying the voltage difference between the local data line LIO and the complementary local data line LIOB.

A principle of amplifying the voltage difference between the local data line LIO and the complementary local data line LIOB by the driving circuit 600 is described above with an example in which the voltage on the local data line LIO is greater than the voltage on the complementary local data line LIOB. A principle adopted when the voltage on the local data line LIO is less than the voltage on the complementary local data line LIOB is similar. Details are not described herein again.

In some embodiments, the driving circuit 600 includes a switch unit 630, a first driving unit 610, and a second driving unit 620. The switch unit 630 is connected to the first driving unit 610. The switch unit 630 is connected to the second driving unit 620. The first driving unit 610 is connected to the local data line LIO and the complementary local data line LIOB. The second driving unit 620 is connected to the local data line LIO and the complementary local data line LIOB.

Connection or disconnection between the first driving unit 610 and a first power supply terminal is controlled by the switch unit 630 under the control of a first control signal RdEnN. Connection or disconnection between the second driving unit 620 and the first power supply terminal is also controlled by the switch unit 630 under the control of the first control signal RdEnN. A voltage provided by the first power supply terminal is a power voltage VCC.

The voltage on the local data line LIO is driven upward by the first driving unit 610 based on the voltage on the complementary local data line LIOB when the first driving unit 610 is connected to the first power supply terminal. The voltage on the complementary local data line LIOB is driven upward by the second driving unit 620 based on the voltage on the local data line LIO when the second driving unit 620 is connected to the first power supply terminal.

A driving capability of the first driving unit 610 in driving the local data line LIO is negatively correlated with the voltage on the complementary local data line LIOB. A driving capability of the second driving unit 620 in driving the complementary local data line LIOB is negatively correlated with the voltage on the local data line LIO.

The first driving unit 610 and the second driving unit 620 are configured to amplify the voltage difference between the local data line LIO and the complementary local data line LIOB. The voltage difference is generated between the local data line LIO and the complementary local data line LIOB, e.g., the voltage on the local data line LIO is greater than the voltage on the complementary local data line LIOB, that is, the voltage on the local data line LIO is large and the voltage on the complementary local data line LIOB is small. The driving capability of the first driving unit 610 in driving the local data line LIO upward is strong when the voltage on the complementary local data line LIOB is small. The driving capability of the second driving unit 620 in driving the complementary local data line LIOB upward is weak when the voltage on the local data line LIO is large. The voltage on the local data line LIO may be caused to be continuously greater than the voltage on the complementary local data line LIOB when the driving capability of the first driving unit 610 in driving the local data line LIO upward is strong and the driving capability of the second driving unit 620 in driving the complementary local data line LIOB upward is weak, thereby amplifying the voltage difference between the local data line LIO and the complementary local data line LIOB.

A principle of amplifying the voltage difference between the local data line LIO and the complementary local data line LIOB by the first driving unit 610 and the second driving unit 620 is described above with an example in which the voltage on the local data line LIO is greater than the voltage on the complementary local data line LIOB. A principle adopted when the voltage on the local data line LIO is less than the voltage on the complementary local data line LIOB is similar. Details are not described herein again.

The switch unit 630 is configured to control the first driving unit 610 and the second driving unit 620 to amplify the voltage difference between the local data line LIO and the complementary local data line LIOB.

The voltage difference between the local data line LIO and the complementary local data line LIOB can be amplified by the first driving unit 610 and the second driving unit 620 when the switch unit 630 controls the first power supply terminal to be connected to the first driving unit 610 and controls the first power supply terminal to be connected to the second driving unit 620.

The voltage difference between the local data line LIO and the complementary local data line LIOB cannot be amplified by the first driving unit 610 and the second driving unit 620 when the switch unit 630 controls the first power supply terminal to be disconnected from the first driving unit 610 and controls the first power supply terminal to be disconnected from the second driving unit 620.

In some embodiments, the switch unit 630 controls, after the local data line LIO and the complementary local data line LIOB are charged to the precharge voltage, the first driving unit 610 to be connected to the first power supply terminal and controls the second driving unit 620 to be connected to the first power supply terminal, to prevent the equalizer circuit 500 from being unable to charge the local data line LIO and the complementary local data line LIOB to the precharge voltage because the first driving unit 610 and the second driving unit 620 are always connected to the first power supply terminal.

In the foregoing technical solution, the switch unit 630 is disposed to control connection between both of the first driving unit 610 and the second driving unit 620 and the first power supply terminal, to implement isolation between the first power supply terminal and a second power supply terminal, thereby preventing the equalizer circuit 500 from being unable to charge the voltages on the local data line LIO and the complementary local data line LIOB to the precharge voltage because the voltage difference between the local data line LIO and the complementary local data line LIOB is always amplified by the first driving unit 610 and the second driving unit 620, and avoiding a failure that accurate data transmission cannot be performed from the bit line BL to the local data line LIO.

In some embodiments, the first driving unit 610 includes a first P-type transistor P1. A source of the first P-type transistor P1 is connected to the switch unit 630. A drain of the first P-type transistor P1 is connected to the local data line LIO. A gate of the first P-type transistor P1 is connected to the complementary local data line LIOB.

The second driving unit 620 includes a second P-type transistor P2. A source of the second P-type transistor P2 is connected to the switch unit 630. A drain of the second P-type transistor P2 is connected to the complementary local data line LIOB. A gate of the second P-type transistor P2 is connected to the local data line LIO.

The switch unit 630 includes a third P-type transistor P3. A source of the third P-type transistor P3 is connected to the first power supply terminal. A drain of the third P-type transistor P3 is connected to the source of the first P-type transistor P1. The drain of the third P-type transistor P3 is further connected to the source of the second P-type transistor P2. The first control signal RdEnN is received by a gate of the third P-type transistor P3.

A lower gate voltage of a P-type transistor indicates a larger turn-on current of the P-type transistor, and a stronger capability of the P-type transistor in pulling up a voltage.

The third P-type transistor P3 is turned on, to control the source of the first P-type transistor P1 to be connected to the first power supply terminal, and control the source of the second P-type transistor P2 to be connected to the first power supply terminal. The voltage difference is generated between the local data line LIO and the complementary local data line LIOB, e.g., the voltage on the local data line LIO is greater than the voltage on the complementary local data line LIOB, that is, the voltage on the local data line LIO is large and the voltage on the complementary local data line LIOB is small. A driving capability of the first P-type transistor P1 in driving the local data line LIO upward is strong when the voltage on the complementary local data line LIOB is small. A driving capability of the second P-type transistor P2 in driving the complementary local data line LIOB upward is weak when the voltage on the local data line LIO is large. The voltage on the local data line LIO may be caused to be continuously greater than the voltage on the complementary local data line LIOB when the driving capability of the first P-type transistor P1 in driving the local data line LIO upward is strong and the driving capability of the second P-type transistor P2 in driving the complementary local data line LIOB upward is weak, thereby amplifying the voltage difference between the local data line LIO and the complementary local data line LIOB.

A principle of amplifying the voltage difference between the local data line LIO and the complementary local data line LIOB by the first P-type transistor P1 and the second P-type transistor P2 is described above with an example in which the voltage on the local data line LIO is greater than the voltage on the complementary local data line LIOB. A principle adopted when the voltage on the local data line LIO is less than the voltage on the complementary local data line LIOB is similar. Details are not described herein again.

In some embodiments, continuing to refer to FIG. 5, the driving circuit 600 further includes a first control circuit 700. A first output terminal of the first control circuit 700 is connected to a control terminal of the switch unit 630. A second output terminal of the first control circuit 700 is connected to a control terminal of the second-stage amplifier circuit 200. A mode signal CTRLPin is received by a first input terminal of the first control circuit 700. A reference signal RdEnPre is received by a second input terminal of the first control circuit 700. The first control circuit 700 is configured to generate the first control signal RdEnN based on the mode signal CTRLPin and the reference signal RdEnPre, and generate a second control signal RdEn based on the reference signal RdEnPre.

The driving circuit 600 is controlled by the first control signal RdEnN to amplify the voltage difference between the local data line LIO and the complementary local data line LIOB. The second-stage amplifier circuit 200 is controlled by the second control signal RdEn to amplify the voltage difference between the local data line LIO and the complementary local data line LIOB.

In some embodiments, the first control signal RdEnN is valid at a low level, and the second control signal RdEn is valid at a high level. The driving circuit 600 is controlled when the first control signal RdEnN is at the low level, to amplify the voltage difference between the local data line LIO and the complementary local data line LIOB. The second-stage amplifier circuit 200 is controlled when the second control signal RdEn is at the high level, to amplify the voltage difference between the local data line LIO and the complementary local data line LIOB.

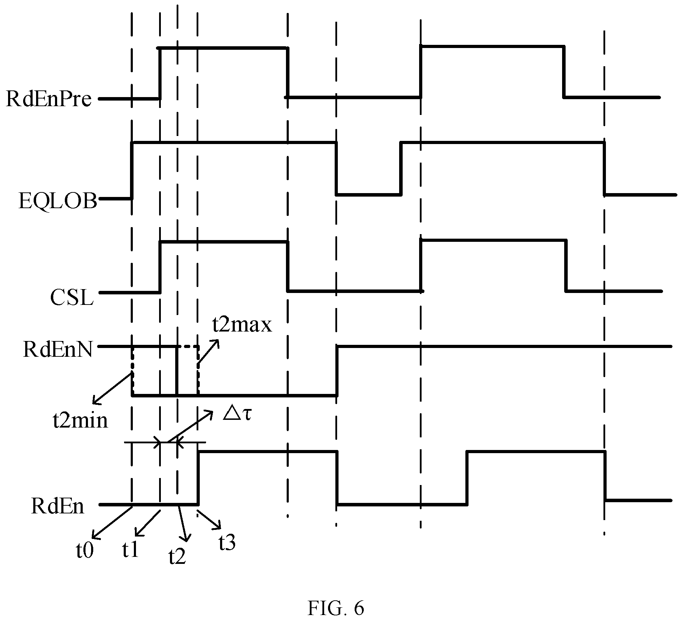

In some embodiments, as shown in FIG. 6, a start moment t2 at which the first control signal RdEnN is in a valid state is earlier than a start moment t3 at which the second control signal RdEn is in a valid state. The driving circuit 600 is first controlled to amplify the voltage difference between the local data line LIO and the complementary local data line LIOB. The second-stage amplifier circuit 200 is then controlled to amplify the voltage difference between the local data line LIO and the complementary local data line LIOB. Through such a disposition, the voltage difference between the local data line LIO and the complementary local data line LIOB is first amplified by the driving circuit 600, to compensate for the impact of the coupling capacitors on the voltages on the local data lines LIO. Then, the second-stage amplifier circuit 200 and the driving circuit 600 together amplify the voltage difference between the local data line LIO and the complementary local data line LIOB, and generate the voltage difference between the global data line GIO and the complementary global data line GIOB. Therefore, the time for amplifying the voltage difference between the local data line LIO and the complementary local data line LIOB by the second-stage amplifier circuit 200 is shortened, and performance of the timing parameter tCCD of the memory is improved.

In some embodiments, as shown in FIG. 6, the start moment t2 at which the first control signal RdEnN is in the valid state is later than an end moment t0 at which an equalization control signal EQLOB is in a valid state. The voltages on the local data line LIO and the complementary local data line LIOB are charged to a precharge voltage when the equalization control signal EQLOB is in the valid state.

In some embodiments, the equalization control signal EQLOB is a signal being valid at a low level, that is, the voltages on the local data line LIO and the complementary local data line LIOB are charged to the precharge voltage when the equalization control signal EQLOB is at the low level.

Through such a disposition, the driving circuit 600 and the second-stage amplifier circuit 200 are controlled after the voltages on the local data line LIO and the complementary local data line LIOB are charged to the precharge voltage, to amplify the voltage difference between the local data line LIO and the complementary local data line LIOB, to implement accurate data transmission between the bit line BL and the local data line LIO and between the complementary bit line BLB and the complementary local data line LIOB.

In some embodiments, the mode signal CTRLPin is configured to adjust the start moment t2 at which the first control signal RdEnN is in the valid state, that is, adjust the start moment at which the driving circuit 600 amplifies the voltage difference between the local data line LIO and the complementary local data line LIOB.

In some embodiments, a minimum value t2min of the start moment at which the first control signal RdEnN is in the valid state is the end moment at which the equalization control signal EQLOB is in the valid state. A maximum value t2max of the start moment at which the first control signal RdEnN is in the valid state is the start moment at which the second control signal RdEn is in the valid state.

In some embodiments, the first control circuit 700 is configured to determine a time step between the reference signal RdEnPre and the first control signal RdEnN based on the mode signal CTRLPin, and process the reference signal RdEnPre based on the time step to generate the first control signal RdEnN.

The time step may be a positive time step, and is marked as △τ. The time step may alternatively be a negative time step, and is marked as -△τ. The positive time step indicates that the start moment t2 at which the first control signal RdEnN is in the valid state is later than the start moment t1 at which the reference signal RdEnPre is in the valid state, and there is a difference △τ between t1 and t2. The negative time step indicates that the start moment t2 at which the first control signal RdEnN is in the valid state is earlier than the start moment t1 at which the reference signal RdEnPre is in the valid state, and there is a difference △τ between t1 and t2.

The mode signal CTRLPin is determined based on any one or more parameters of a first time interval, a process angle of the memory, a temperature of the memory, and an operating voltage of the memory. The first time interval is a time interval between adjacent row addressing and column addressing of the memory.

In some embodiments, the mode signal CTRLPin is determined based on the first time interval. A shorter first time interval indicates a larger time step corresponding to the mode signal CTRLPin, and a later start moment at which the first control signal RdEnN is in the valid state.

A smaller absolute value of the negative time step -△τ indicates a larger negative time step when the time step is the negative time step -△τ. A larger absolute value of the positive time step Δτ indicates a larger positive time step when the time step is the positive time step △τ.

In some embodiments, the mode signal CTRLPin is determined based on any one or more parameters of a process angle of the memory, a temperature of the memory, and an operating voltage of the memory. Multiple tests may be performed on the memory to determine a relationship between the start moment at which the first control signal RdEnN is in the valid state and each of the process angle of the memory, the temperature of the memory, and the operating voltage of the memory, to reduce the noise introduced to the bit line BL and the complementary bit line BLB.

Through such a disposition, the start moment at which the driving circuit 600 amplifies the voltage difference between the local data line LIO and the complementary local data line LIOB is adjusted when the timing parameter of the memory is poor, to reduce the noise introduced by the local data line LIO and the complementary local data line LIOB to the bit line BL and the complementary bit line BLB, and implement accurate data transmission.

In some embodiments, the reference signal RdEnPre is a column selection signal CSL. Connection or disconnection between the bit line BL and the local data line LIO and connection or disconnection between the complementary bit line BLB and the complementary local data line LIOB are controlled by the second control circuit 400 under the control of the column selection signal CSL.

In some embodiments, the reference signal RdEnPre is not limited to the column selection signal CSL, and may be any other signal, provided that the first control signal RdEnN meets the foregoing timing relationship. This is not limited herein.

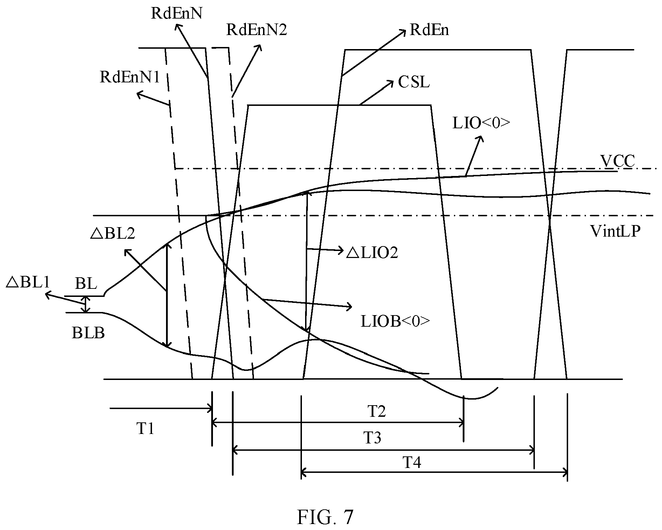

An operating principle of the memory described in this embodiment of the present disclosure is described below with reference to FIG. 7.

In a phase T1, the column selection signal CSL is at a low level, the bit line BL is disconnected from the local data line LIO, and the complementary bit line BLB is disconnected from the complementary local data line LIOB. Data " 1" is stored in the storage cell. Charge sharing is performed between the storage cell and the bit line BL. In this case, a small voltage difference △BL1 is generated between the bit line BL and the complementary bit line BLB. The small voltage difference △BL1 between the bit line BL and the complementary bit line BLB is amplified by the first-stage amplifier circuit 100 in the phase T1, e.g., amplified to a voltage difference △BL2.

In a phase T2, the column selection signal CSL is at a high level, the bit line BL is connected to the local data line LIO, and the complementary bit line BLB is connected to the complementary local data line LIOB. Data on the bit line BL and the complementary bit line BLB is transmitted to the local data line LIO and the complementary local data line LIOB. In this case, a voltage on a middle local data line LIO<0> is affected by local data lines LIO<2> and LIO<3> on two sides due to a coupling capacitor if voltage jump occurs on the local data lines LIO<2> and LIO<3> on the two sides because data "0" is transmitted, but the data "1" is transmitted on the middle local data line LIO<1>, that is, the voltage on the middle local data line LIO is close to the precharge voltage VintLP.

In a phase T3, the first control signal RdEnN is at the low level, and the third P-type transistor P3 is turned on. The voltage on the local data line LIO is driven upward by the first P-type transistor P1. The voltage on the complementary local data line LIOB is driven upward by the second P-type transistor P2. The driving capability of the first P-type transistor P1 in pulling up the local data line LIO is better than the driving capability of the second P-type transistor P2 in pulling up the complementary local data line LIOB. In this way, an impact of the local data lines LIO<2> and LIO<3> on the two sides on the middle local data line LIO<0> is compensated for. In this case, the voltage on the complementary local data line LIOB is driven downward by the complementary bit line BLB, to compensate for the impact of the local data lines LIO<2> and LIO<3> on the two sides on a voltage on the middle local data line LIO<0>, and amplify the voltage difference between the local data line LIO and the complementary local data line LIOB.

In a phase T4, the second control signal RdEn is at the high level. The second-stage amplifier circuit 200 starts to amplify the voltage difference between the local data line LIO and the complementary local data line LIOB. In this case, the voltage difference △LIO2 is already large because the voltage difference between the local data line LIO and the complementary local data line LIOB is already amplified by the driving circuit 600. The second-stage amplifier circuit 200 and the driving circuit 600 together amplify the voltage difference between the local data line LIO and the complementary local data line LIOB. Therefore, the time for amplifying the voltage difference between the local data line LIO and the complementary local data line LIOB by the second-stage amplifier circuit 200 can be shortened.

In FIG. 7, an example in which the data "1" is stored in the storage cell is used for description. A case in which the data "0" is stored in the storage cell is similar to the case in which the data "1" is stored in the storage cell. Details are not described herein again.

Continuing to refer to FIG. 7, the start moment at which the first control signal RdEnN is in the valid state may be adjusted between a start moment indicated by RdEnN1 and a start moment indicated by RdEnN2, to adjust a size of the noise introduced by the local data line LIO and the complementary local data line LIOB to the bit line BL and the complementary bit line BLB.

It should be understood that the present disclosure is not limited to the precise structures described above and shown in the accompanying drawings, and various modifications and changes may be made without departing from the scope thereof. The scope of the present disclosure is limited only by the appended claims.

## Claims

1. A memory, comprising:
a first-stage amplifier circuit (100), connected to a bit line (BL) and a complementary bit line (BLB), and configured to amplify a voltage difference between the bit line and the complementary bit line;
a second-stage amplifier circuit (200), connected to a local data line (LIO) and a complementary local data line (LIOB), further connected to a global data line (GIO) and a complementary global data line (GIOB), amplifying a voltage difference between the local data line and the complementary local data line after the local data line is connected to the bit line and the complementary local data line is connected to the complementary bit line, and generating a voltage difference between the global data line and the complementary global data line; and
a driving circuit (600), connected to the local data line and the complementary local data line, and amplifying the voltage difference between the local data line and the complementary local data line;
wherein the driving circuit is configured to:
amplify the voltage difference between the local data line and the complementary local data line by driving a voltage on the local data line and/or a voltage on the complementary local data line upward; and
a driving capability of driving the local data line upward is negatively correlated with the voltage on the complementary local data line, and a driving capability of driving the complementary local data line upward is negatively correlated with the voltage on the local data line;
wherein the driving circuit comprises:
a switch unit (630), connected to a first driving unit and a second driving unit, controlling connection or disconnection between the first driving unit and a first power supply terminal under the control of a first control signal, and controlling connection or disconnection between the second driving unit and the first power supply terminal under the control of the first control signal, the first power supply terminal providing a power voltage;
the first driving unit (610), connected to the local data line and the complementary local data line, and driving the voltage on the local data line upward based on the voltage on the complementary local data line when the first driving unit is connected to the first power supply terminal; and
the second driving unit (620), connected to the local data line and the complementary local data line, and driving the voltage on the complementary local data line upward based on the voltage on the local data line when the second driving unit is connected to the first power supply terminal; and
a driving capability of the first driving unit in driving the local data line is negatively correlated with the voltage on the complementary local data line, and a driving capability of the second driving unit in driving the complementary local data line is negatively correlated with the voltage on the local data line;
**characterised in that** the driving circuit further comprises:
a first control circuit (700), a first output terminal being connected to a control terminal of the switch unit, a second output terminal being connected to a control terminal of the second-stage amplifier circuit, and a first input terminal receiving a mode signal and a second input terminal receiving a reference signal to generate the first control signal based on the mode signal and the reference signal and generate a second control signal based on the reference signal; and
a start moment at which the first control signal is in a valid state is earlier than a start moment at which the second control signal is in a valid state, and the second-stage amplifier circuit is controlled by the second control signal to amplify the voltage difference between the local data line and the complementary local data line;
wherein the control circuit is configured to:
determine a time step between the reference signal and the first control signal based on the mode signal; and
process the reference signal based on the time step to generate the first control signal;
wherein the mode signal is determined based on any one or more parameters of a first time interval, a process angle of the memory, a temperature of the memory, and an operating voltage of the memory; and
the first time interval is a time interval between adjacent row addressing and column addressing of the memory.

2. The memory according to claim 1, wherein the memory further comprises:
an equalizer circuit (500), connected to the local data line and the complementary local data line, and charging voltages on the local data line and the complementary local data line to a precharge voltage before the local data line is connected to the bit line and the complementary local data line is connected to the complementary bit line; and
the driving circuit is configured to amplify the voltage difference between the local data line and the complementary local data line after the voltages on the local data line and the complementary local data line are charged to the precharge voltage.

3. The memory according to claim 1 or 2, wherein a start moment at which the driving circuit amplifies the voltage difference between the local data line and the complementary local data line is earlier than a start moment at which the second-stage amplifier circuit amplifies the voltage difference between the local data line and the complementary local data line.

4. The memory according to claim 1, wherein
the first driving unit comprises:
a first P-type transistor (P1), a source being connected to the switch unit, a drain being connected to the local data line, and a gate being connected to the complementary local data line; and
the second driving unit comprises:
a second P-type transistor (P2), a source being connected to the switch unit, a drain being connected to the complementary local data line, and a gate being connected to the local data line.

5. The memory according to claim 4, wherein the switch unit comprises:
a third P-type transistor (P3), a source being connected to the first power supply terminal, a drain being connected to the source of the first P-type transistor, the drain being further connected to the source of the second P-type transistor, and a gate receiving the first control signal.

6. The memory according to claim 1, wherein the start moment at which the first control signal is in the valid state is later than an end moment at which an equalization control signal is in a valid state, and the voltages on the local data line and the complementary local data line are charged to a precharge voltage when the equalization control signal is in the valid state.

7. The memory according to claim 1, wherein the reference signal is a column selection signal, and the column selection signal is configured to control connection or disconnection between the bit line and the local data line, and is further configured to control connection or disconnection between the complementary bit line and the complementary local data line.

8. The memory according to claim 1, wherein the memory further comprises:
a second control circuit (400), connected to the bit line and the complementary bit line, further connected to the local data line and the complementary local data line, and configured to receive a column selection signal, control connection or disconnection between the bit line and the local data line under the control of the column selection signal, and control connection or disconnection between the complementary bit line and the complementary local data line under the control of the column selection signal.

9. The memory according to claim 1, wherein the memory further comprises:
a third-stage amplifier circuit (300), connected to the global data line and the complementary global data line, and configured to amplify the voltage difference between the global data line and the complementary global data line.

## Patentansprüche

1. Speicher, umfassend:
eine Verstärkerschaltung (100) der ersten Stufe, die mit einer Bitleitung (BL) und einer komplementären Bitleitung (BLB) verbunden ist und eingerichtet ist zum Verstärken einer Spannungsdifferenz zwischen der Bitleitung und der komplementären Bitleitung;
eine Verstärkerschaltung (200) der zweiten Stufe, die mit einer lokalen Datenleitung (LIO) und einer komplementären lokalen Datenleitung (LIOB) verbunden ist, ferner verbunden mit einer globalen Datenleitung (GIO) und einer komplementären globalen Datenleitung (GIOB), die eine Spannungsdifferenz zwischen der lokalen Datenleitung und der komplementären lokalen Datenleitung verstärkt, nachdem die lokale Datenleitung mit der Bitleitung verbunden ist und die komplementäre lokale Datenleitung mit der komplementären Bitleitung verbunden ist, und eine Spannungsdifferenz zwischen der globalen Datenleitung und der komplementären globalen Datenleitung erzeugt; und
eine Treiberschaltung (600), die mit der lokalen Datenleitung und der komplementären lokalen Datenleitung verbunden ist und die Spannungsdifferenz zwischen der lokalen Datenleitung und der komplementären lokalen Datenleitung verstärkt;
wobei die Treiberschaltung eingerichtet ist zum:
Verstärken der Spannungsdifferenz zwischen der lokalen Datenleitung und der komplementären lokalen Datenleitung durch Aufwärtstreiben einer Spannung auf der lokalen Datenleitung und/oder einer Spannung auf der komplementären lokalen Datenleitung; und
wobei eine Treiberfähigkeit zum Aufwärtstreiben der lokalen Datenleitung negativ korreliert ist mit der Spannung auf der komplementären lokalen Datenleitung, und eine Treiberfähigkeit zum Aufwärtstreiben der komplementären lokalen Datenleitung negativ korreliert ist mit der Spannung auf der lokalen Datenleitung;
wobei die Treiberschaltung Folgendes umfasst:
eine Schalteinheit (630), die mit einer ersten Treibereinheit und einer zweiten Treibereinheit verbunden ist, die eine Verbindung oder Trennung zwischen der ersten Treibereinheit und einem ersten Stromversorgungsanschluss unter der Steuerung eines ersten Steuersignals steuert, und eine Verbindung oder Trennung zwischen der zweiten Treibereinheit und dem ersten Stromversorgungsanschluss unter der Steuerung des ersten Steuersignals steuert, der eine Versorgungsspannung bereitstellt;
die erste Treibereinheit (610), die mit der lokalen Datenleitung und der komplementären lokalen Datenleitung verbunden ist und die Spannung auf der lokalen Datenleitung basierend auf der Spannung auf der komplementären lokalen Datenleitung aufwärtstreibt, wenn die erste Treibereinheit mit dem ersten Stromversorgungsanschluss verbunden ist; und
die zweite Treibereinheit (620), die mit der lokalen Datenleitung und der komplementären lokalen Datenleitung verbunden ist und die Spannung auf der komplementären lokalen Datenleitung basierend auf der Spannung auf der lokalen Datenleitung aufwärtstreibt, wenn die zweite Treibereinheit mit dem ersten Stromversorgungsanschluss verbunden ist; und
wobei eine Treiberfähigkeit der ersten Treibereinheit beim Treiben der lokalen Datenleitung negativ korreliert ist mit der Spannung auf der komplementären lokalen Datenleitung, und eine Treiberfähigkeit der zweiten Treibereinheit beim Treiben der komplementären lokalen Datenleitung negativ korreliert ist mit der Spannung auf der lokalen Datenleitung;
**dadurch gekennzeichnet, dass** die Treiberschaltung ferner Folgendes umfasst:
eine erste Steuerschaltung (700), wobei ein erster Ausgangsanschluss mit einem Steueranschluss der Schalteinheit verbunden ist, ein zweiter Ausgangsanschluss mit einem Steueranschluss der Verstärkerschaltung der zweiten Stufe verbunden ist, und ein erster Eingangsanschluss ein Modussignal empfängt und ein zweiter Eingangsanschluss ein Referenzsignal empfängt, um das erste Steuersignal basierend auf dem Modussignal und dem Referenzsignal zu erzeugen und ein zweites Steuersignal basierend auf dem Referenzsignal zu erzeugen; und
wobei ein Startzeitpunkt, an dem das erste Steuersignal in einem gültigen Zustand ist, früher ist als ein Startzeitpunkt, an dem das zweite Steuersignal in einem gültigen Zustand ist, und die Verstärkerschaltung der zweiten Stufe durch das zweite Steuersignal gesteuert wird, um die Spannungsdifferenz zwischen der lokalen Datenleitung und der komplementären lokalen Datenleitung zu verstärken;
wobei die Steuerschaltung eingerichtet ist zum:
Bestimmen eines Zeitschritts zwischen dem Referenzsignal und dem ersten Steuersignal basierend auf dem Modussignal; und
Verarbeiten des Referenzsignals basierend auf dem Zeitschritt, um das erste Steuersignal zu erzeugen;
wobei das Modussignal basierend auf einem oder mehreren beliebigen Parametern eines ersten Zeitintervalls, einer Prozessecke des Speichers, einer Temperatur des Speichers und einer Betriebsspannung des Speichers bestimmt wird; und
das erste Zeitintervall ein Zeitintervall zwischen benachbarter Zeilenadressierung und Spaltenadressierung des Speichers ist.

2. Speicher nach Anspruch 1, wobei der Speicher ferner Folgendes umfasst:
eine Ausgleichsschaltung (500), die mit der lokalen Datenleitung und der komplementären lokalen Datenleitung verbunden ist und Spannungen auf der lokalen Datenleitung und der komplementären lokalen Datenleitung auf eine Vorladespannung lädt, bevor die lokale Datenleitung mit der Bitleitung verbunden wird und die komplementäre lokale Datenleitung mit der komplementären Bitleitung verbunden wird; und
wobei die Treiberschaltung eingerichtet ist zum Verstärken der Spannungsdifferenz zwischen der lokalen Datenleitung und der komplementären lokalen Datenleitung, nachdem die Spannungen auf der lokalen Datenleitung und der komplementären lokalen Datenleitung auf die Vorladespannung geladen sind.

3. Speicher nach Anspruch 1 oder 2, wobei ein Startzeitpunkt, an dem die Treiberschaltung die Spannungsdifferenz zwischen der lokalen Datenleitung und der komplementären lokalen Datenleitung verstärkt, früher ist als ein Startzeitpunkt, an dem die Verstärkerschaltung der zweiten Stufe die Spannungsdifferenz zwischen der lokalen Datenleitung und der komplementären lokalen Datenleitung verstärkt.

4. Speicher nach Anspruch 1, wobei
die erste Treibereinheit Folgendes umfasst:
einen ersten P-Typ-Transistor (P1), wobei eine Source mit der Schalteinheit verbunden ist, ein Drain mit der lokalen Datenleitung verbunden ist und ein Gate mit der komplementären lokalen Datenleitung verbunden ist; und
die zweite Treibereinheit Folgendes umfasst:
einen zweiten P-Typ-Transistor (P2), wobei eine Source mit der Schalteinheit verbunden ist, ein Drain mit der komplementären lokalen Datenleitung verbunden ist und ein Gate mit der lokalen Datenleitung verbunden ist.

5. Speicher nach Anspruch 4, wobei die Schalteinheit Folgendes umfasst:
einen dritten P-Typ-Transistor (P3), wobei eine Source mit dem ersten Stromversorgungsanschluss verbunden ist, ein Drain mit der Source des ersten P-Typ-Transistors verbunden ist, wobei das Drain ferner mit der Source des zweiten P-Typ-Transistors verbunden ist, und ein Gate das erste Steuersignal empfängt.

6. Speicher nach Anspruch 1, wobei der Startzeitpunkt, an dem das erste Steuersignal in dem gültigen Zustand ist, später ist als ein Endzeitpunkt, an dem ein Ausgleichssteuersignal in einem gültigen Zustand ist, und die Spannungen auf der lokalen Datenleitung und der komplementären lokalen Datenleitung auf eine Vorladespannung geladen sind, wenn das Ausgleichssteuersignal im gültigen Zustand ist.

7. Speicher nach Anspruch 1, wobei das Referenzsignal ein Spaltenauswahlsignal ist, und das Spaltenauswahlsignal eingerichtet ist zum Steuern der Verbindung oder Trennung zwischen der Bitleitung und der lokalen Datenleitung, und ferner eingerichtet ist zum Steuern der Verbindung oder Trennung zwischen der komplementären Bitleitung und der komplementären lokalen Datenleitung.

8. Speicher nach Anspruch 1, wobei der Speicher ferner Folgendes umfasst:
eine zweite Steuerschaltung (400), die mit der Bitleitung und der komplementären Bitleitung verbunden ist, ferner mit der lokalen Datenleitung und der komplementären lokalen Datenleitung verbunden ist, und eingerichtet ist zum Empfangen eines Spaltenauswahlsignals, zum Steuern der Verbindung oder Trennung zwischen der Bitleitung und der lokalen Datenleitung unter der Steuerung des Spaltenauswahlsignals, und zum Steuern der Verbindung oder Trennung zwischen der komplementären Bitleitung und der komplementären lokalen Datenleitung unter der Steuerung des Spaltenauswahlsignals.

9. Speicher nach Anspruch 1, wobei der Speicher ferner Folgendes umfasst:
eine Verstärkerschaltung (300) der dritten Stufe, die mit der globalen Datenleitung und der komplementären globalen Datenleitung verbunden ist und eingerichtet ist zum Verstärken der Spannungsdifferenz zwischen der globalen Datenleitung und der komplementären globalen Datenleitung.

## Revendications

1. Mémoire, comprenant :
un circuit amplificateur de premier étage (100), connecté à une ligne de bits (BL) et à une ligne complémentaire de bits (BLB), et configuré pour amplifier une différence de tension entre la ligne de bits et la ligne complémentaire de bits ;
un circuit amplificateur de deuxième étage (200), connecté à une ligne de données locales (LIO) et à une ligne complémentaire de données locales (LIOB), en outre connecté à une ligne de données globales (GIO) et à une ligne complémentaire de données globales (GIOB), amplifiant une différence de tension entre la ligne de données locales et la ligne complémentaire de données locales après que la ligne de données locales a été connectée à la ligne de bits et que la ligne complémentaire de données locales a été connectée à la ligne complémentaire de bits, et générant une différence de tension entre la ligne de données globales et la ligne complémentaire de données globales ; et
un circuit d'entraînement (600), connecté à la ligne de données locales et à la ligne complémentaire de données locales, et amplifiant la différence de tension entre la ligne de données locales et la ligne complémentaire de données locales ;
dans laquelle le circuit d'entraînement est configuré pour :
amplifier la différence de tension entre la ligne de données locales et la ligne complémentaire de données locales en entraînant une tension sur la ligne de données locales et/ou une tension sur la ligne complémentaire de données locales vers le haut ; et
une capacité d'entraînement pour entraîner la ligne de données locales vers le haut est corrélée négativement avec la tension sur la ligne complémentaire de données locales, et une capacité d'entraînement pour entraîner la ligne complémentaire de données locales vers le haut est corrélée négativement avec la tension sur la ligne de données locales ;
dans laquelle le circuit d'entraînement comprend :
une unité de commutation (630), connectée à une première unité d'entraînement et à une deuxième unité d'entraînement, commandant une connexion ou déconnexion entre la première unité d'entraînement et un premier terminal d'alimentation sous la commande d'un premier signal de commande, et commandant une connexion ou déconnexion entre la deuxième unité d'entraînement et le premier terminal d'alimentation sous la commande du premier signal de commande, le premier terminal d'alimentation fournissant une tension d'alimentation ;
la première unité d'entraînement (610), connectée à la ligne de données locales et à la ligne complémentaire de données locales, et entraînant la tension sur la ligne de données locales vers le haut en fonction de la tension sur la ligne complémentaire de données locales lorsque la première unité d'entraînement est connectée au premier terminal d'alimentation ; et
la deuxième unité d'entraînement (620), connectée à la ligne de données locales et à la ligne complémentaire de données locales, et entraînant la tension sur la ligne complémentaire de données locales vers le haut en fonction de la tension sur la ligne de données locales lorsque la deuxième unité d'entraînement est connectée au premier terminal d'alimentation ; et
une capacité d'entraînement de la première unité d'entraînement lors de l'entraînement de la ligne de données locales est corrélée négativement avec la tension sur la ligne complémentaire de données locales, et une capacité d'entraînement de la deuxième unité d'entraînement lors de l'entraînement de la ligne complémentaire de données locales est corrélée négativement avec la tension sur la ligne de données locales ;
**caractérisée en ce que**, le circuit d'entraînement comprend en outre :
un premier circuit de commande (700), un premier terminal de sortie connecté à un terminal de commande de l'unité de commutation, un deuxième terminal de sortie connecté à un terminal de commande du circuit amplificateur de deuxième étage, et un premier terminal d'entrée recevant un signal de mode et un deuxième terminal d'entrée recevant un signal de référence pour générer le premier signal de commande en fonction du signal de mode et du signal de référence, et générer un deuxième signal de commande en fonction du signal de référence ; et
un moment de départ auquel le premier signal de commande est dans un état valide précède un moment de départ auquel le deuxième signal de commande est dans un état valide, et le circuit amplificateur de deuxième étage est commandé par le deuxième signal de commande pour amplifier la différence de tension entre la ligne de données locales et la ligne complémentaire de données locales ;
dans laquelle le circuit de commande est configuré pour :
déterminer un pas de temps entre le signal de référence et le premier signal de commande en fonction du signal de mode ; et
traiter le signal de référence en fonction du pas de temps pour générer le premier signal de commande ;
dans laquelle le signal de mode est déterminé en fonction d'un ou plusieurs paramètres quelconques parmi un premier intervalle de temps, un angle de traitement de la mémoire, une température de la mémoire et une tension de fonctionnement de la mémoire ; et
le premier intervalle de temps est un intervalle de temps entre un adressage de lignes adjacentes et un adressage de colonnes de la mémoire.

2. Mémoire selon la revendication 1, dans laquelle la mémoire comprend en outre :
un circuit égaliseur (500), connecté à la ligne de données locales et à la ligne complémentaire de données locales, et chargeant des tensions sur la ligne de données locales et la ligne complémentaire de données locales à une tension de précharge avant que la ligne de données locales ne soit connectée à la ligne de bits et que la ligne complémentaire de données locales ne soit connectée à la ligne complémentaire de bits ; et
le circuit d'entraînement est configuré pour amplifier la différence de tension entre la ligne de données locales et la ligne complémentaire de données locales après que les tensions sur la ligne de données locales et la ligne complémentaire de données locales ont été chargées à la tension de précharge.

3. Mémoire selon la revendication 1 ou 2, dans laquelle un moment de départ auquel le circuit d'entraînement amplifie la différence de tension entre la ligne de données locales et la ligne complémentaire de données locales précède un moment de départ auquel le circuit amplificateur de deuxième étage amplifie la différence de tension entre la ligne de données locales et la ligne complémentaire de données locales.

4. Mémoire selon la revendication 1, dans laquelle,
la première unité d'entraînement comprend :
un premier transistor de type P (P1), une source connectée à l'unité de commutation, un drain connecté à la ligne de données locales, et une grille connectée à la ligne complémentaire de données locales ; et
la deuxième unité d'entraînement comprend :
un deuxième transistor de type P (P2), une source connectée à l'unité de commutation, un drain connecté à la ligne complémentaire de données locales, et une grille connectée à la ligne de données locales.

5. Mémoire selon la revendication 4, dans laquelle l'unité de commutation comprend :
un troisième transistor de type P (P3), une source connectée au premier terminal d'alimentation, un drain connecté à la source du premier transistor de type P, le drain étant en outre connecté à la source du deuxième transistor de type P, et une grille recevant le premier signal de commande.

6. Mémoire selon la revendication 1, dans laquelle le moment de départ auquel le premier signal de commande est dans l'état valide est plus tard qu'un moment de fin auquel un signal de commande d'égalisation est dans un état valide, et les tensions sur la ligne de données locales et la ligne complémentaire de données locales sont chargées à une tension de précharge lorsque le signal de commande d'égalisation est dans l'état valide.

7. Mémoire selon la revendication 1, dans laquelle le signal de référence est un signal de sélection de colonne, et le signal de sélection de colonne est configuré pour commander une connexion ou déconnexion entre la ligne de bits et la ligne de données locales, et est en outre configuré pour commander une connexion ou déconnexion entre la ligne complémentaire de bits et la ligne complémentaire de données locales.

8. Mémoire selon la revendication 1, dans laquelle la mémoire comprend en outre :
un deuxième circuit de commande (400), connecté à la ligne de bits et à la ligne complémentaire de bits, en outre connecté à la ligne de données locales et à la ligne complémentaire de données locales, et configuré pour recevoir un signal de sélection de colonne, commander une connexion ou déconnexion entre la ligne de bits et la ligne de données locales sous la commande du signal de sélection de colonne, et commander une connexion ou déconnexion entre la ligne complémentaire de bits et la ligne complémentaire de données locales sous la commande du signal de sélection de colonne.

9. Mémoire selon la revendication 1, dans laquelle la mémoire comprend en outre :
un circuit amplificateur de troisième étage (300), connecté à la ligne de données globales et à la ligne complémentaire de données globales, et configuré pour amplifier la différence de tension entre la ligne de données globales et la ligne complémentaire de données globales.
